# EUROPEAN PATENT APPLICATION

(11) **EP 2 369 625 A2**
(43) Date of publication of application: **28.09.2011**
(21) Application number: 11159889.2
(22) Date of filing: 25.03.2011
(51) Int. Cl.: H01L 27/146

(54) **Housing assembly structure and housing assembling method**

(30) Priority: 26.03.2010 JP 2010072578
(71) Applicant: Yamatake Corporation, Tokyo 100-6419 (JP)
(72) Inventor: Soeda, Kenichi, Tokyo 100-6419 (JP); Mizobuchi, Manabu, Tokyo 100-6419 (JP)
(74) Representative: Tomlinson, Kerry John

(57) **Abstract**

There is provided a housing assembly structure (5). The structure (5) includes: a case (2) comprising: a first side wall (21) and; a cover (3) jointed to the case (2) and including a second side wall (31), wherein the second side wall (31) and the first side wall (21) are engaged with each other and welded to each other by irradiation of laser light, One of the first side wall (21) and the second side wall (31) is an outer wall which allows laser light to pass therethrough, and the other of the first side wall (21) and the second side wall (31) is an inner wall which absorbs the laser light passing through the outer wall.

## Description

### Technical Field

The present invention relates to a housing assembly structure and a housing assembling method when a plurality of components is joined by laser welding to form a housing.

### Related Art

There is a housing assembling method of joining a case and a cover by laser welding to form a housing in which a substrate such as a photoelectric sensor is housed. This method contributes to a miniaturization compared to a housing assembling method by an integral molding, an adhesion or the like.

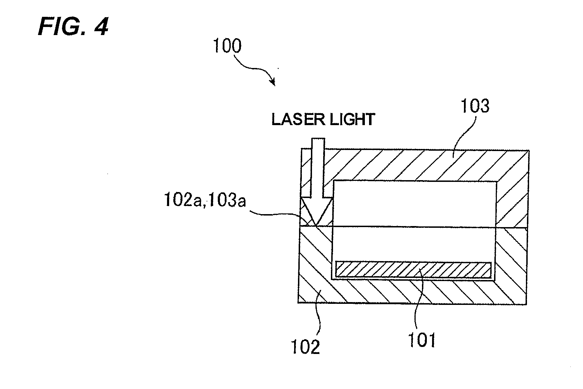

In the housing assembling method by the related-art laser welding, as shown in Fig. 4, firstly, a substrate 101 of a photoelectric sensor 100 is received in a case 102 which is formed of a light transmitting resin having the absorptiveness with respect to a laser light, such as polycarbonate containing a carbon filler, and then, for example, a cover 103 formed of a light transmitting resin having the permeability with respect to a laser light, such as polyacrylate is attached thereto. Next, by an irradiation means (not shown), a laser light is irradiated from an upper part of the cover 103 to contact surfaces 102a and 103a between the case 102 and the cover 103. Herein, the irradiated laser light penetrates the cover 102 formed of the light transmitting resin and is irradiated onto the contact surface 102a of the case 102 formed of the light absorbent resin. Next, the contact surface 102a is heated and melted by the irradiation of the laser light, and the contact surface 103a is also melted by the heating of the contact surface 102a. As a result, the contact surface 102a and the contact surface 103a are welded, which can join the case 102 and the cover 103 (*see e.g.,* JP-A-2008-285330).

However, even in a case where there is a need to further widen a substrate area to be received in the housing in the housing assembling method disclosed in JP-A-2008-285330, in order to avoid an overly large scale of the housing, there is a case where outer sizes of the housing cannot sufficiently be enlarged. In that case, in order to further enlarge the substrate area, there is a need to provide a substrate of a large area in a receivable manner, by making a thickness of a side wall forming the contact surfaces 102a and 103a between the case 102 and the cover 103 thinly and enlarging the inner size according to the thin thickness. However, according to such method, the areas of the contact surfaces 102a and 103a become relatively smaller, and, as a result, the area of the surface (the welding surface) to be welded by the irradiation of the laser light also becomes smaller. For this reason, there is a concern that a necessary welding strength cannot be obtained.

Furthermore, even in a case where the substrate areas to be received in the housing are identical to each other, and there is a need to reduce outer sizes of the housing, there is a need to reduce the areas of the contact surfaces 102a and 103a that are welding surfaces between the case 102 and the cover 103. Even in this case, there is a concern that a necessary welding strength cannot be obtained.

Furthermore, even in a case where there is a need to reduce the outer sizes of the housing to further widen the substrate area to be received in the housing, similarly, there is a need to reduce the areas of the contact surfaces 102a and 103a that are the welding surfaces between the case 102 and the cover 103, and there is a concern that a necessary welding strength cannot be obtained.

Furthermore, JP-A-2008-285330 describes a problem in that, when the welding surface between the case 102 and the cover 103 is reduced, a welding portion due to the irradiation of the laser light reaches end portions of the welding surface, resin is jetted out or an assembly accuracy in a thickness direction of the housing cannot be secured.
As mentioned above, when the housing is miniaturized and comes to have a high density, there is a problem in that a necessary welding strength cannot be obtained, and the jetting out of resin, a decline in assembly accuracy or the like occurs.

### SUMMARY

It is an illustrative aspect of the present invention to provide a housing assembly structure and a housing assembling method which can obtain a necessary welding strength even in a case where the housing is miniaturized and comes to have a high density.

According to one or more illustrative aspects of the present invention, there is provided a housing assembly structure. The structure comprises: a case comprising a first side wall; a cover jointed to the case and comprising a second side wall, wherein the second side wall and the first side wall are engaged with each other and welded to each other by irradiation of laser light. One of the first side wall and the second side wall is an outer wall which allows laser light to pass therethrough, and the other of the first side wall and the second side wall is an inner wall which absorbs the laser light passing through the outer wall.

According to one or more illustrative aspects of the present invention, there is provided a housing assembly structure. The structure comprises: a case comprising a first side wall; a cover jointed to the case and comprising a second side wall, wherein an end surface of the first side wall and an end surface of the second side wall come into contact with each other and welded to each other by irradiation of laser light. The end surface of the first side wall is inclined with respect to the first side wall, and the end surface of the second side wall is inclined with respect to the second side wall. One of the first side wall and the second side wall is an outer wall which allows laser light to pass therethrough, and the other of the first side wall and the second side wall is an inner wall which absorbs the laser light passing through the outer wall.

According to one or more illustrative aspects of the present invention, there is provided a housing assembly method comprising: (a) providing a case comprising a first side wall; (b) providing a cover comprising a second side wall; (c) engaging the first side wall of the case and the second side wall of the cover with each other; and (d) welding the first side wall and the second side wall to each other by irradiating laser light. One of the first side wall and the second side wall is an outer wall which allows laser light to pass therethrough, and the other of the first side wall and the second side wall is an inner wall which absorbs the laser light passing through the outer wall.

According to one or more illustrative aspects of the present invention, there is provided a housing assembly method comprising: (a) providing a case comprising a first side wall; (b) providing a cover comprising a second side wall; (c) contacting an end surface of the first side wall of the case and an end surface of the second side wall of the cover with each other; and (d) welding the first side wall and the second side wall to each other by irradiating laser light. The end surface of the first side wall is inclined with respect to the first side wall, and the end surface of the second side wall is inclined with respect to the second side wall. One of the first side wall and the second side wall is an outer wall which allows laser light to pass therethrough, and the other of the first side wall and the second side wall is an inner wall which absorbs the laser light passing through the outer wall.

According to the present invention, with the above-mentioned configuration, in a contact portion between the case and the cover, by extending an outer wall of any one of the case or the cover, a light penetrating welding wall surface having a permeability with respect to a laser light to be irradiated is formed, and by extending an inner wall of the other thereof, a light absorbing welding wall surface is formed which has an absorptiveness with respect to the laser light irradiated via the light transmitting welding wall surface and is welded with the light transmitting welding wall surface by the irradiation of the laser light, whereby, even in the case of miniaturization and high density of the housing, a necessary welding strength can be obtained.

### BRIEF DESCRIPTION OF THE DRAWINGS

Fig. 1 is a cross-sectional view showing a configuration of a photoelectric sensor using a housing assembly structure according to a first embodiment of the present invention;
Fig. 2 is a cross-sectional view showing a configuration of a photoelectric sensor using a housing assembly structure according to a second embodiment of the present invention;
Fig. 3 is a cross-sectional view showing a configuration of a cover in the second embodiment of the present invention; and
Fig. 4 is a cross-sectional view showing a configuration of a photoelectric sensor using a related-art housing assembly structure.

### DETAILED DESCRIPTION OF EXEMPLARY EMBODIMENTS

Hereinafter, exemplary embodiments of the present invention will be now described with reference to the drawings.

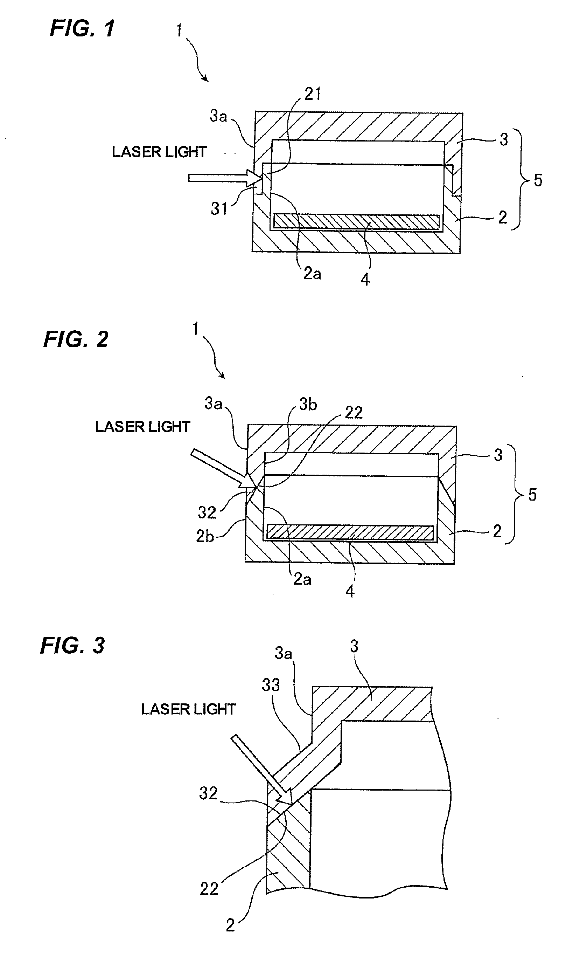

Fig. 1 is a cross-sectional view showing a configuration of a photoelectric sensor 1 using a housing assembly structure according to a first embodiment of the preset invention.
As shown in Fig. 1, the photoelectric sensor 1 includes a case 2, a cover 3 and a substrate 4.

The case 2 fixes and receives the substrate 4 and is formed in a box-like shape whose upper surface is opened. The case 2 is formed of a light absorbent resin having an absorbing property with respect to a laser light. In the case 2, by extending the whole periphery of an inner wall 2a of a contact portion with the cover 3, a light absorbing welding wall surface 21 is formed. The light absorbing welding wall surface 21 is irradiated with a laser light via a light penetrating welding wall surface 31 (described later) of the cover 3 and is welded with the light penetrating welding wall surface 31.
In addition, the light absorbing welding wall surface 21 at least comes into contact with the light penetrating welding wall surface 31 and may be constituted in only a side surface portion of the inner wall 2a that is irradiated with the laser light via the light penetrating welding wall surface 31.

The cover 3 constitutes an integrated housing 5 by being joined to the case 2 by laser welding and is formed in a box-like shape whose lower surface is opened. The cover 3 is formed of a light transmitting resin having a permeability with respect to the laser light. On the cover 3, the light penetrating welding wall surface 31 is formed by extending the whole periphery of the outer wall 3a side of the contact portion with the case 2. The light penetrating welding wall surface 31 is fitted into the light absorbing welding wall surface 21 and is irradiated with the laser light, and then is welded with the light absorbing welding wall surface 21.

In addition, the heights of the light absorbing welding wall surface 21 and light penetrating welding wall surface 31 are designed to be heights such that the tensile strength of the case 2 and the cover 3 can be secured by the shear strength due to the welding of the light absorbing welding wall surface 21 and the light penetrating welding wall surface 31.

Next, a housing assembling method of the photoelectric sensor 1 configured as above will be now described.
In assembling the photoelectric sensor 1, firstly, after the substrate 4 of the photoelectric sensor is fixed and received in the case 2, the cover 3 is attached to the case 2, and the light absorbing welding wall surface 21 and the light penetrating welding wall surface 31 are fitted into each other (a fitting step).

Next, by an irradiation means (not shown), as shown in Fig. 1, the laser light is irradiated vertically to the welding wall surfaces 21 and 31 (a laser welding step). At this time, the irradiated laser light penetrates the light penetrating welding wall surface 31 formed of a light transmitting resin and is irradiated to the light absorbing welding wall surface 21 formed of a light absorbent resin.
Next, the light absorbing welding wall surface 21 is heated and melted by being irradiated with the laser light, and the light penetrating welding wall surface 31 is also melted by the heating of the light absorbing welding wall surface 21. As a result, the light absorbing welding wall surface 21 and the light penetrating welding wall surface 31 are welded, which can join the case 2 and the cover 3.

In this manner, according to the first embodiment, the welding wall surfaces 21 and 31 are formed in the contact portion between the case 2 and the cover 3 to carry out the laser welding, whereby it is possible to secure the tensile strength of the case 2 and the cover 3 by the shear strength due to the welding of the welding wall surfaces 21 and 31. Thus, even in a case where there is a need for miniaturization and high density of the housing 5, a necessary welding strength can be obtained.

In addition, in the first embodiment, by extending the inner wall 2a side of the case 2, the light absorbing welding wall surface 21 is formed, and by extending the outer wall 3a side of the cover 3, the light penetrating welding wall surface 31 is formed. However, the cover 3 may be formed of a light absorbent resin, thereby forming the light absorbing welding wall surface by extending the inner wall side of the contact portion with the case 2, and the case 2 may be formed of a light transmitting resin, thereby forming the light transmitting wall surface by extending the outer wall side of the contact portion with the cover 3.

### SECOND EMBODIMENT

In the first embodiment, by forming the welding wall surfaces 21 and 31 on the case 2 and the cover 3, the tensile strength of the cover 2 and the cover 3 is secured by the shear strength due to the welding of the welding wall surfaces 21 and 31. However, a second embodiment shows that the tensile strength of the case 2 and the cover 3 is secured by the shear strength and the tensile strength due to the welding of welding slope surfaces 22 and 32 by forming the welding slope surfaces 22 and 32 on the case 2 and the cover 3.

Fig. 2 is a cross-sectional view showing a configuration of the photoelectric sensor 1 using the housing structure according to the second embodiment of the invention. In the photoelectric sensor 1 according to the second embodiment shown in Fig. 2, the light absorbing welding wall surface 21 of the photoelectric sensor 1 according to the first embodiment shown in Fig. 1 is changed to the light absorbing welding slope surface 22, and the light penetrating welding wall surface 31 is changed to the light transmitting welding slope surface 32. The remaining configurations are almost identical, the same reference numerals are denoted and the descriptions thereof will be omitted hereinafter.

In the light absorbing welding slope surface 22, the inner wall 2a side is formed to be high relative to the outer wall side 2b in the whole periphery of the contact portion with the cover portion 3. The light absorbing welding slope surface 22 is irradiated with the laser light via the light transmitting welding slope surface 32, and is welded with the light transmitting welding slope surface 32.
In the light transmitting welding slope surface 32, the outer wall 3a side is formed to be high relative to the inner wall side 3b in the whole periphery of the contact portion with the case 2. The light transmitting welding slope surface 32 is irradiated with the laser light after being fitted into the light absorbing welding slope surface 22, and is welded with the light absorbing welding slope surface 22.

Next, the housing assembling method of the photoelectric sensor 1 will be now described.
In assembling the photoelectric sensor 1, firstly, the substrate 4 of the photoelectric sensor is fixed and received in the case 2 and then the cover 3 is attached to the case 2, thereby fitting the light absorbing welding slope surface 22 and the light transmitting welding slope surface 32 into each other (a fitting step).

Next, by an irradiation means (not shown), as shown in Fig. 2, the laser light is irradiated vertically to the welding slope surfaces 22 and 32 (a laser welding step). At this time, the irradiated laser light penetrates the light transmitting welding slope surface 32 formed of the light transmitting resin and is irradiated onto the light absorbing welding slope surface 22 formed of the light transmitting resin.
Next, the light absorbing welding slope surface 22 is heated and melted by being irradiated with the laser light, and the light transmitting welding slope surface 32 is also melted by the heating of the light absorbing welding slope surface 22. As a result, the light absorbing welding slope surface 22 and the light transmitting welding slope surface 32 are welded, which can join the case 2 and the cover 3.

As mentioned above, according to the second embodiment, since the laser welding is performed on the welding slope surfaces 22 and 32 that are formed in the contact portion between the case 2 and the cover 3, it is possible to secure the tensile strength of the case 2 and the cover 3 by the shear strength and the tensile strength due to the welding of the welding slope surfaces 22 and 32. Thus, even when there is a need for miniaturization and high density of the housing 5, the necessary welding strength can be obtained.

In the second embodiment, since the laser light is irradiated vertically to the light transmitting welding slope surface 32 of the slope surface shape, the laser light is obliquely incident to the outer wall 3 a surface of the cover 3. For this reason, there is a concern that the laser light is refracted by the oblique incidence to the outer wall 3a surface and the irradiation position is deviated. Thus, for example, as shown in Fig. 3, the incident surface 33 of the cover 3, into which the laser light is incident, may be configured so as to be perpendicular to the laser light.

Furthermore, in the second embodiment, the light absorbing welding slope surface 22 having the inner wall 2a side higher than the outer wall 2b side is formed on the case 2, and the light transmitting welding slope surface 32 having the outer wall 3a side higher than the inner wall 3b side is formed on the cover 3. However, the cover 3 may be formed of light absorbent resin to form the light absorbing welding slope surface having the inner wall 3b side higher than the outer wall 3a side, and the case 2 may be formed of the light transmitting resin to form the light transmitting welding slope surface having the outer wall 2b side higher than the inner wall 2a side.

Furthermore, in the first and second embodiments, in the whole periphery of the contact portion between the case 2 and the cover 3, the welding wall surfaces 4 and 5 or the welding slope surfaces 6 and 7 are formed. However, it may be preferable if enough welding strength can be obtained when the case 2 and the cover 3 are welded. Also, the welding wall surfaces 4 and 5 or the welding slope surfaces 6 and 7 may be formed only in a part of the contact portion, thereby performing the joint in combination with the related art welding method.

Moreover, in the first and second embodiments, the case 2 itself is formed of the light absorbent resin and the cover 3 itself is formed of the light transmitting resin, but at least the welding wall surface portions 21 and 31 or the welding slope surface portions 22 and 32 may be formed of the light absorbent resin and the light transmitting resin.
Furthermore, as the light transmitting resin, polyacrylate can be used, and as the light absorbent resin polycarbonate or polybutylene terephthalate containing the carbon filler can be used, but the materials of each resin are not limited thereto, in brief, any material may be used which suitably welds the case 2 and the cover 3 by the laser light irradiated from the outer wall direction of the housing 5.

Furthermore, in the first and second embodiments, the description is made using the photoelectric sensor as an electronic appliance, the present invention can also be similarly applied to other electronic appliances without being limited thereto.

## Claims

1. A housing assembly structure (5) comprising:
a case (2) comprising a first side wall (21); and
a cover (3) jointed to the case (2) and comprising a second side wall (31), wherein the second side wall (31) and the first side wall (21) are engaged with each other and welded to each other by irradiation of laser light,
wherein one of the first side wall (21) and the second side wall (31) is an outer wall which allows laser light to pass therethrough, and
wherein the other of the first side wall (21) and the second side wall (31) is an inner wall which absorbs the laser light passing through the outer wall.

2. A housing assembly structure (5) comprising:
a case (2) comprising a first side wall (22); and
a cover (3) jointed to the case (2) and comprising a second side wall (32), wherein an end surface of the first side wall (22) and an end surface of the second side wall (32) come into contact with each other and welded to each other by irradiation of laser light, and
wherein the end surface of the first side wall (22) is inclined with respect to the first side wall, and the end surface of the second side wall (32) is inclined with respect to the second side wall,
wherein one of the first side wall (22) and the second side wall (32) is an outer wall which allows laser light to pass therethrough, and
wherein the other of the first side wall (22) and the second side wall (32) is an inner wall which absorbs the laser light passing through the outer wall.

3. A housing assembly method comprising:
(a) providing a case (2) comprising a first side wall (21);
(b) providing a cover (3) comprising a second side wall (31);
(c) engaging the first side wall (21) of the case (2) and the second side wall (31) of the cover (3) with each other; and
(d) welding the first side wall (21) and the second side wall (31) to each other by irradiating laser light,
wherein one of the first side wall (21) and the second side wall (31) is an outer wall which allows laser light to pass therethrough, and
wherein the other of the first side wall (21) and the second side wall (31) is an inner wall which absorbs the laser light passing through the outer wall.

4. A housing assembly method comprising:
(a) providing a case (2) comprising a first side wall (22);
(b) providing a cover (3) comprising a second side wall (32);
(c) contacting an end surface of the first side wall (22) of the case (2) and an end surface of the second side wall (32) of the cover (3) with each other; and
(d) welding the first side wall (22) and the second side wall (32) to each other by irradiating laser light,
wherein the end surface of the first side wall (22) is inclined with respect to the first side wall, and the end surface of the second side wall (32) is inclined with respect to the second side wall,
wherein one of the first side wall (21) and the second side wall (31) is an outer wall which allows laser light to pass therethrough, and
wherein the other of the first side wall (21) and the second side wall (31) is an inner wall which absorbs the laser light passing through the outer wall.
